Europäisches Patentamt

European Patent Office

Office européen des brevets

(19)

(11) Publication number: **0 301 655**
**A1**

(12) **EUROPEAN PATENT APPLICATION**

(21) Application number: **88201568.8**

(22) Date of filing: **20.07.88**

(51) Int. Cl.⁴: **H01L 39/24** , //C04B35/00

(30) Priority: **29.07.87 NL 8701787**

(43) Date of publication of application:
**01.02.89 Bulletin 89/05**

(84) Designated Contracting States:
**DE ES FR GB IT NL SE**

(71) Applicant: **N.V. Philips' Gloeilampenfabrieken**
**Groenewoudseweg 1**
**NL-5621 BA Eindhoven(NL)**

(72) Inventor: **Severin, Jan Willem**
c/o **INT. OCTROOIBUREAU B.V. Prof.**
**Holstlaan 6**
**NL-5656 AA Eindhoven(NL)**
Inventor: **De With, Gijsbertus**
c/o **INT. OCTROOIBUREAU B.V. Prof.**
**Holstlaan 6**
**NL-5656 AA Eindhoven(NL)**

(74) Representative: **Pennings, Johannes et al**
**Internationaal Octrooibureau B.V. Prof.**
**Holstlaan 6**
**NL-5656 AA Eindhoven(NL)**

(54) Method for preparing an oxidic superconductor material.

(57) A fine-granular superconductive material, in particular $YBa_2Cu_3O_{7-\delta}$, is obtained by spray-drying an aqueous nitrate solution of the desired metal ions and subjecting the resulting powder to an oxidic treatment at high temperature. A very homogeneous bulky superconductive material can be manufactured with the resulting powder.

EP 0 301 655 A1

## Method of manufacturing oxidic superconductive material.

The invention relates to a method of manufacturing powdered or bulky oxidic superconductive material and to the resulting powdered material.

A method of manufacturing powdered oxidic superconductive material from an aqueous solution which comprises the desired metal ions in the desired stoechiometric ratio is described in an article by S.M. Johnson et al. in Advanced Ceramic Materials 2 (3B), pp. 337-342 (1987). The powder is obtained by freeze drying and has a primary grain size from 0.5 to 1 $\mu$m.

The invention relates in particular to a method of manufacturing $YBa_2Cu_3O_{7-\delta}$. This material in which $\sigma = 0.1-0.5$, shows superconductive behaviour at temperatures below 92 k.

A method of manufacturing a Ba-La-Cu-O-containing superconductive material in which a mixture of oxalates of the desired metal atoms is formed by means of coprecipitation from an aqueous nitrate solution, which mixture is then decomposed at a high temperature after which the product is compressed to a bulk material and is sintered, is described in an article by J.G. Bednorz and K.A. Müller in Z.Phys.B - Condensed Matter 64, pp. 189-193 (1986). Instead of oxalates, for example, citrates are sometimes used for this purpose. Although the resulting material is fine-granular it has been found to be not possible to sinter this material to a high density.

A method of manufacturing $YBa_2Cu_3O_{7-\delta}$, in which a mixture of powdered $Y_2O_3$, $BaCO_3$ and $CuO$ is heated in an oxidizing atmosphere after which the resulting material is ground, again heated for a long period of time, compressed to form pills and sintered, is described in an article by P.M. Grant a.o., in Physical Review B, 35 (13), pp. 7242-7244 (1987). Instead of the said starting materials, hydroxides, peroxides or nitrates are sometimes used for this purpose. Such methods provide powder having a primary particle size from 10 to 100 $\mu$m which in addition coagulate together in hard aggregates.

A method of preparing superconductive material in which superconductive thin layers are provided on a hot substrate in an oxygen-containing atmosphere by means of electron beam vapour deposition by using various sources is described in an article by R.B. Laibowitz a.o., in Physical Review B, 35 (16), pp. 8821-8823 (1987). Such a method is not suitable for the manufacture of powdered or bulky material.

A problem of the recently discovered oxidic superconductive materials is the low value of the critical magnetic field and the critical current, that is to say of the value above which the material no longer shows any superconductive behaviour. The mechanical properties, for example, strength and corrosion resistance, also leave to be desired. Although by means of epitaxial growth thin layers can be made which show higher critical values, the manufacture of epitaxial layers and single crystals is difficult and expensive. Nor is it simple to process epitaxial layers and single crystals or bring them in a desired shape, for example, a wire shape.

It is the object of the invention to provide a method with which a fine-granular oxidic superconductive material can be manufactured, for example having a primary particle size smaller than 0.3 $\mu$m, which can be sintered to a homogeneous material with high density without any problems.

Another object of the invention is to provide a method of manufacturing a homogeneous bulky superconductive material of high density.

According to the invention, these objects are achieved by means of a method according to which an aqueous solution is prepared which comprises the desired metal ions in the desired stoechiometric ratio after which the solution is spray-dried and the resulting powder is then kept at a temperature of 725 to 850°C for at least 10 minutes, after which the powder is cooled. The aqueous solution is preferably a nitrate solution.

For the manufacture of powdered $YBa_2Cu_3O_{7-\delta}$ an aqueous solution is used which comprises the metal ions $Y^{3+}$, $Ba^{2+}$ and $Cu^{2+}$ in a ratio of 1 : 2: 3, and the treatment is carried out at 725 to 850°C in an oxidizing atmosphere.

The method according to the invention may also be used for the manufacture of other powdered superconductive materials, for example, Ca, Sr and Bi-containing cuprates, which are superconductive at temperatures below approximately 110 K. It is only important for the decomposition temperature of the nitrates used to be lower than 750°C.

In order to obtain bulky oxidic superconductive material the powder is compressed isostatically at a pressure of 1 to 20 kbar and a temperature lower than 350°C and is sintered at a temperature of 750 to 900°C.

The invention will be described in greater detail with reference to a specific example.

### Example

A solution in water of yttrium nitrate, barium nitrate and copper (II) nitrate in which the metal ions $Y^{3+}$, $Ba^{2+}$ and $Cu^{2+}$ are present in a molar ratio of 1 : 2 : 3, is spray-dried. The resulting powder is placed in an air-ventilated furnace preheated at 750°C and is stored therein for 15 minutes so that a rapid decomposition of the compounds occurs. The powder is then taken out of the furnace, it being cooled to room temperature in a few minutes.

It has been established by means of X-ray diffraction that the resulting powder consists for approximately 98% of $YBa_2Cu_3O_{7-\delta}$ with an orthorombic structure and for the balance of $Y_2O_3$, $CuO$, $BaCuO_2$ and $Ba_2Cu_3O_x$.

The primary particle size of the powder is approximately 0.25 $\mu$m and the powder comprises only soft agglomerates.

By means of cold compression (room temperature) at a high pressure (10 kbar) and sintering at 750°C a bulk material is obtained which has a density of 95 to 100% of the theoretical density, which is very homogeneous and in which the grain size is smaller than 3 $\mu$m. It has also been established that the intermediary phases still present in the powder after sintering are completely converted into orthorombic $YBa_2Cu_3O_{7-\delta}$.

A spray grid or a "fluid-bed" reactor may also be used instead of a pre-heated furnace.

## Claims

1. A method of manufacturing a powdered oxidic superconductive material from an aqueous solution which comprises the desired metal ions in the desired stoechiometric ratio, characterized in that the solution is spray-dried after which the resulting powder is brought in a pre-heated furnace and is kept at a temperature of 725 to 850°C for at least 10 minutes after which the powder is cooled.

2. A method as claimed in Claim 1 of manufacturing powdered $YBa_2Cu_3O_{7-\delta}$, in which the aqueous solution comprises the metal ions $Y^{3+}$, $Ba^{2+}$ and $Cu^{2+}$ in a ratio of 1 : 2 : 3 and in which the treatment at a temperature of 725 to 850°C is carried out in an oxidizing atmosphere.

3. A method of manufacturing bulky oxidic superconductive material in which the powder obtained by means of the method as claimed in Claim 1 or 2 is compressed isostatically at a pressure of from 1 to 20 kbar and a temperature lower than 450°C and is sintered at a temperature of 750 to 900°C.

4. Powdered oxidic superconductive material manufactured by means of the method as claimed in Claim 1 or 2, characterized in that the primary grain size of the powder is smaller than 0.3 $\mu$m.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | ADVANCED CERAMIC MATERIALS, Band 2, Nr. 3B, Juli 1987, "Special Issue", Seiten 444-456, ACerS, Westerville, OH, US; G.W. CRABTREE et al.: "Fabrication, mechanical properties, heat capacity, oxygen diffusion and the effect of alkali earth ion substitution on high Tc superconductors" * Seiten 444-445 * --- | 1-4 | H 01 L 39/24 // C 04 B 35/00 |
| D,A | ADVANCED CERAMIC MATERIALS, Band 2, Nr. 3B, Juli 1987, "Special Issue", Seiten 337-342, ACerS, Westerville OH, US; S.M. JOHNSON et al.: "Preparation of superconducting powders by freeze-drying" * Seite 338, Absatz "Experimental" * ----- | 1 | |

| RECHERCHIERTE SACHGEBIETE (Int. Cl.4) |
|---|
| H 01 L 39 |

Der vorliegende Recherchenbericht wurde für alle Patentansprüche erstellt

| Recherchenort | Abschlußdatum der Recherche | Prüfer |
|---|---|---|
| DEN HAAG | 31-10-1988 | PELSERS L. |

EPO FORM 1503 03.82 (P0403)